# EUROPÄISCHE PATENTSCHRIFT

(11) **EP 3 469 637 B1**
(45) Veröffentlichungstag und Bekanntmachung des Hinweises auf die Patenterteilung: **02.12.2020**
(21) Anmeldenummer: 17726946.1
(22) Anmeldetag: 31.05.2017
(51) Int. Cl.: H01L 41/12, H01F 1/03, H02N 2/02

(54) **AKTORVORRICHTUNG UND VERWENDUNG EINER AKTORVORRICHTUNG**
ACTUATOR DEVICE AND USE OF AN ACTUATOR DEVICE
SYSTÈME D'ACTIONNEUR ET L'UTILISATION D'UN DISPOSITIF D'ACTIONNEMENT

(30) Priorität: 09.06.2016 DE 102016110669
(43) Veröffentlichungstag der Anmeldung: 17.04.2019
(73) Patentinhaber: Eto Magnetic GmbH, 78333 Stockach (DE)
(72) Erfinder: LAUFENBERG, Markus, 78333 Stockach (DE); SCHIEPP, Thomas, 78606 Seitingen-Oberflacht (DE)
(74) Vertreter: Daub, Thomas
(86) Internationale Anmeldenummer: PCT/EP2017/063154
(87) Internationale Veröffentlichungsnummer: WO 2017/211643

(56) Entgegenhaltungen:
- DE-A1-102013 221 744
- US-A1- 2010 242 673
- US-A1- 2016 087 553

## Beschreibung

### Stand der Technik

Die Erfindung geht aus von einer Aktorvorrichtung nach dem Oberbegriff des Anspruchs 1 und von einem Verfahren mit einer Aktorvorrichtung nach dem Oberbegriff des Anspruchs 21.

Aus der US 2016/0087553 A1 ist eine Aktorvorrichtung bekannt, welche ein Aktorelement aus einem magnetischen Formgedächtnislegierungsmaterial (auch bekannt als MSM-Material = Magnetic Shape Memory) sowie eine Magneteinheit zur Beeinflussung des Aktorelements aufweist, wobei die Magneteinheit ausschließlich aus Spulen besteht.

Ferner ist aus der US 9,091,251 B1 eine Aktorvorrichtung bekannt, wobei ein aus einem magnetischen Formgedächtnislegierungsmaterial bestehendes Aktorelement mittels drehbar gelagerter Permanentmagnete beeinflussbar ist.

Aus der DE 10 2013 221 744 A1 ist zudem eine Fluidpumpe bekannt, welche einen Pumpenkörper aus einem magnetischen Formgedächtnislegierungsmaterial sowie eine Magneteinheit zur Beeinflussung des Pumpenkörpers aufweist, wobei die Magneteinheit ausschließlich aus Spulen besteht. In der Patentschrift US20100242673 wird ein Aktor bestehend aus einem Antriebselement (26) und zwei Ausdehnungseinheiten (10,22), die aus einem Formgedächnismaterial geformt sind, offenbart.

Die Aufgabe der Erfindung besteht insbesondere darin, eine gattungsgemäße Aktorvorrichtung mit verbesserten Eigenschaften hinsichtlich einer Effizienz bereitzustellen. Die Aufgabe wird durch die kennzeichnenden Merkmale der Patentansprüche 1 und 21 gelöst, während vorteilhafte Ausgestaltungen und Weiterbildungen der Erfindung den Unteransprüchen entnommen werden können.

### Vorteile der Erfindung

Die Erfindung geht aus von einer Aktorvorrichtung mit zumindest einem Aktorelement, welches zumindest teilweise, vorzugsweise zu wenigstens einem Großteil und besonders bevorzugt vollständig, aus einem magnetisch formveränderlichen Material besteht, und mit einer Magneteinheit, welche zumindest ein als Spuleneinheit ausgebildetes erstes Magnetelement und zumindest ein als Permanentmagnet ausgebildetes zweites Magnetelement umfasst.

Es wird vorgeschlagen, dass zumindest das erste Magnetelement und das zweite Magnetelement dazu vorgesehen sind, in zumindest einem Betriebszustand zusammenzuwirken, um eine lokale Verformung des Aktorelements in einem Teilbereich, vorteilhaft einem Randbereich, des Aktorelements zu bewirken. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt. Unter dem Ausdruck "zu wenigstens einem Großteil" sollen dabei insbesondere zumindest 55 %, vorteilhaft zumindest 65 %, vorzugsweise zumindest 75 %, besonders bevorzugt zumindest 85 % und besonders vorteilhaft zumindest 95 % verstanden werden.

Unter einer "Aktorvorrichtung" soll in diesem Zusammenhang insbesondere zumindest ein Teil, insbesondere eine Unterbaugruppe, eines Aktors verstanden werden. Vorteilhaft ist die Aktorvorrichtung zumindest zu einer Verwendung in einer Fluidpumpe, insbesondere einer Mikropumpe, beispielsweise zur Verwendung im Automobilbereich und/oder Medizinbereich, und/oder einem Positionierungssystem, insbesondere optischen Positionierungssystem, insbesondere zur Positionierung optischer Bauelemente, wie beispielsweise Spiegel, Linsen und/oder anderer Optiken, vorgesehen. Insbesondere kann die Aktorvorrichtung dabei auch ein, vorteilhaft als Außengehäuse ausgebildetes, Aktorgehäuse, insbesondere zumindest zur Aufnahme des Aktorelements und/oder der Magneteinheit, umfassen. Unter einem "Aktorelement" soll insbesondere ein Element verstanden werden, das insbesondere dazu vorgesehen ist, einen externen Stimulus, wie beispielsweise ein elektrisches Signal, ein thermisches Signal, ein mechanisches Signal und/oder vorteilhaft zumindest ein magnetisches Signal, in eine Bewegung umzusetzen. Insbesondere ist das Aktorelement dabei zumindest teilweise formveränderlich ausgebildet und insbesondere dazu vorgesehen, abhängig von dem externen Stimulus eine Form zu verändern. Vorzugsweise ist dabei ein Volumen des Aktorelements konstant. Besonders vorteilhaft ist das Aktorelement einstückig ausgebildet. Unter "einstückig" soll in diesem Zusammenhang insbesondere zumindest stoffschlüssig verbunden und/oder miteinander ausgebildet verstanden werden. Der Stoffschluss kann beispielsweise durch einen Klebeprozess, einen Anspritzprozess, einen Schweißprozess, einen Lötprozess und/oder einen anderen Prozess hergestellt werden. Vorteilhaft soll unter einstückig jedoch aus einem Stück und/oder in einem Stück geformt verstanden werden. Ferner soll unter einem "magnetisch formveränderlichen Material" insbesondere ein Material verstanden werden, welches mittels eines, insbesondere äußeren, Magnetfelds beeinflussbar ist und vorteilhaft in zumindest einem Betriebszustand dazu vorgesehen ist, zumindest abhängig von dem Magnetfeld eine Form zu verändern.

Ferner soll unter einer "Magneteinheit" insbesondere eine Einheit verstanden werden, welche dazu vorgesehen ist, in zumindest einem Betriebszustand ein, insbesondere auf das Aktorelement einwirkendes, Magnetfeld bereitzustellen und/oder zu erzeugen und hierdurch insbesondere eine Verformung des Aktorelements zu beeinflussen. Darunter, dass ein Objekt ein weiteres Objekt "beeinflusst" soll in diesem Zusammenhang insbesondere verstanden werden, dass das weitere Objekt bei einer Abwesenheit und/oder Inaktivität des Objekts einen anderen Zustand, eine andere Form und/oder eine andere Lage aufweist und/oder annimmt als bei einer Anwesenheit und/oder Aktivität des Objekts. Vorteilhaft ist die Magneteinheit dazu vorgesehen, ein Magnetfeld bereitzustellen, welches senkrecht zu einer Längserstreckung des Aktorelements ausgerichtet ist. Besonders bevorzugt ist die Magneteinheit dazu vorgesehen, insbesondere mittels des Magnetfelds, in zumindest einem Anwendungszustand eine Formveränderung des Aktorelements zu bewirken. Darüber hinaus ist die Magneteinheit vorteilhaft zumindest teilweise in einem Nahbereich des Aktorelements angeordnet. Unter einem "Nahbereich" soll insbesondere ein räumlicher Bereich verstanden werden, welcher aus Punkten gebildet ist, die weniger als ein Drittel, vorzugsweise weniger als ein Viertel, bevorzugt weniger als ein Sechstel und besonders bevorzugt weniger als ein Zehntel einer minimalen Längserstreckung des Aktorelements von einem Referenzpunkt und/oder einem Referenzbauteil, insbesondere dem Aktorelement, entfernt sind und/oder die jeweils einen Abstand von höchstens 20 mm, vorzugsweise von höchstens 10 mm und besonders bevorzugt von höchstens 5 mm von einem Referenzpunkt und/oder einem Referenzbauteil, insbesondere dem Aktorelement, aufweisen. Ferner soll unter einer "Längserstreckung" eines, insbesondere länglichen, Objekts insbesondere eine maximale Erstreckung des Objekts verstanden werden. Insbesondere definiert die Längserstreckung des Objekts dabei eine Längserstreckungsrichtung des Objekts. Unter einem als "Spuleneinheit" ausgebildeten Magnetelement soll insbesondere ein Magnetelement mit zumindest einer Spule und/oder einer Verschaltung mehrerer Spulen, verstanden werden. Darüber hinaus besteht ein, insbesondere als Permanentmagnet ausgebildetes, Magnetelement insbesondere zumindest teilweise, vorzugsweise zu wenigstens einem Großteil und besonders bevorzugt vollständig, aus einem Permanentmagnetwerkstoff. In diesem Zusammenhang soll unter einem "Permanentmagnetwerkstoff" insbesondere ein Magnetwerkstoff verstanden werden, welcher, insbesondere nach einer anfänglichen Magnetisierung, eine Remanenz aufweist. Vorteilhaft weist der Permanentmagnetwerkstoff dabei eine Remanenzflussdichte von zumindest 0,2 T, insbesondere von zumindest 0,4 T und insbesondere von zumindest 0,6 T, auf.

Darunter, dass "zwei Magnetelemente dazu vorgesehen sind, zusammenzuwirken" soll insbesondere verstanden werden, dass die Magnetelemente jeweils ein Einzelmagnetfeld erzeugen und/oder bereitstellen, welche sich insbesondere derart überlagern, dass sich ein, insbesondere resultierendes und/oder gemeinsames, Magnetfeld, vorteilhaft in einem Bereich des Aktorelements, verändert, insbesondere reduziert und/oder erhöht, insbesondere um zumindest 10 %, vorteilhaft um zumindest 30 % und besonders vorteilhaft um zumindest 50 %, insbesondere im Vergleich zu den Einzelmagnetfeldern, wobei insbesondere das, insbesondere resultierende und/oder gemeinsame, Magnetfeld eine Verformung des Aktorelements bewirkt. Darüber hinaus soll unter einer "lokalen Verformung des Aktorelements in einem Teilbereich des Aktorelements" insbesondere eine, insbesondere rein, lokale Verformung des Aktorelements verstanden werden, welche vollständig in dem Teilbereich des Aktorelements angeordnet ist. Insbesondere weist der Teilbereich dabei eine Erstreckungslänge auf, welche höchstens 85 %, vorteilhaft höchstens 65 %, vorzugsweise höchstens 45 % und besonders bevorzugt höchstens 25 % einer zu der Erstreckungslänge des Teilbereichs korrespondierenden und/oder zumindest im Wesentlichen parallel angeordneten Erstreckungslänge des Aktorelements entspricht. Insbesondere ist das Aktorelement dabei in einem von dem Teilbereich verschiedenen Teilbereich unverformt. Besonders bevorzugt ist der Teilbereich ein Teilbereich einer Längsseite des Aktorelements, welche sich insbesondere in eine Längserstreckungsrichtung des Aktorelements erstreckt, wobei die lokale Verformung insbesondere vollständig in der Längsseite des Aktorelements angeordnet ist. Vorteilhaft weist die lokale Verformung ferner eine, insbesondere zumindest im Wesentlichen parallel zur Längserstreckungsrichtung des Aktorelements angeordnete, Erstreckungslänge, vorteilhaft Längserstreckung, auf, welche höchstens 85 %, vorteilhaft höchstens 65 %, vorzugsweise höchstens 45 % und besonders bevorzugt höchstens 25 % der Längserstreckung des Aktorelements entspricht. Bevorzugt weist die lokale Verformung zumindest bei einer Betrachtung senkrecht zur Längserstreckungsrichtung des Aktorelements eine zumindest im Wesentlichen halbellipsenförmige Kontur auf. Die lokale Verformung könnte dabei beispielsweise als lokale Erhöhung ausgebildet sein. Vorteilhaft ist die lokale Verformung jedoch als lokale Vertiefung und/oder Mulde ausgebildet. In diesem Zusammenhang soll unter "zumindest im Wesentlichen parallel" insbesondere eine Ausrichtung einer Richtung relativ zu einer Bezugsrichtung, insbesondere in einer Ebene, verstanden werden, wobei die Richtung gegenüber der Bezugsrichtung eine Abweichung insbesondere kleiner als 8°, vorteilhaft kleiner als 5° und besonders vorteilhaft kleiner als 2° aufweist. Ferner soll unter einem "zumindest im Wesentlichen halbellipsenförmigen" Objekt insbesondere ein Objekt verstanden werden, welches von einem halbellipsenförmigen Referenzobjekt mit einem Flächenanteil von höchstens 20 %, vorzugsweise von höchstens 15 % und besonders bevorzugt von höchstens 10 % abweicht. Durch diese Ausgestaltung kann eine Aktorvorrichtung mit verbesserten Eigenschaften hinsichtlich einer Effizienz, insbesondere einer Energieeffizienz, einer Bauteileeffizienz, einer Bauraumeffizienz und/oder einer Kosteneffizienz, bereitgestellt werden. Darüber hinaus kann vorteilhaft eine Wärmeentwicklung, wie beispielsweise bei einer ausschließlichen Verwendung von Elektromagneten, reduziert werden. Zudem kann vorteilhaft eine besonders kompakte Aktorvorrichtung bereitgestellt werden. Darüber hinaus kann vorteilhaft eine Ansteuerung, insbesondere der Magneteinheit, vereinfacht werden. Ferner kann eine vorteilhaft geräuscharme Aktorvorrichtung bereitgestellt werden.

Vorzugsweise sind zumindest das erste Magnetelement und das zweite Magnetelement dazu vorgesehen, in zumindest einem weiteren Betriebszustand zusammenzuwirken, um eine, insbesondere rein, lokale Verformung des Aktorelements in einem zumindest teilweise und vorzugsweise vollständig von dem Teilbereich verschiedenen weiteren Teilbereich, vorteilhaft weiteren Randbereich, des Aktorelements zu bewirken. Vorteilhaft liegt der weitere Randbereich des Aktorelements dem Randbereich des Aktorelements gegenüber, insbesondere bezüglich der Längserstreckung des Aktorelements. Insbesondere könnte der weitere Betriebszustand dabei mit dem Betriebszustand identisch sein. Bevorzugt ist der weitere Betriebszustand jedoch von dem Betriebszustand verschieden. Bevorzugt ist in dem weiteren Betriebszustand der Teilbereich des Aktorelements unverformt und/oder frei von einer lokalen Verformung. Hierdurch kann insbesondere eine gleichzeitige und/oder abwechselnde Betätigung mehrerer Objekte und/oder eine vorteilhafte Pumpwirkung erreicht werden.

Sind zumindest das erste Magnetelement und das zweite Magnetelement dazu vorgesehen, ein, insbesondere gemeinsames, veränderliches Magnetfeld zu erzeugen, um eine Bewegung der lokalen Verformung von dem Teilbereich zu dem weiteren Teilbereich zu bewirken, kann insbesondere eine besonders einfache Pumpbewegung erreicht werden. Bevorzugt sind zumindest das erste Magnetelement und das zweite Magnetelement dazu vorgesehen, eine zumindest im Wesentlichen gleichförmige Bewegung zu erzeugen. Unter der Wendung "zumindest im Wesentlichen gleichförmig" soll dabei insbesondere im Rahmen einer Einstellgenauigkeit und/oder im Rahmen technischer Möglichkeiten gleichförmig verstanden werden.

Das magnetisch formveränderliche Material könnte beispielsweise einem magnetostriktiven Material entsprechen. Vorteilhaft ist das magnetisch formveränderliche Material jedoch ein magnetisch wirksames und/oder aktives Formgedächtnismaterial, insbesondere ein magnetisches Formgedächtnismaterial, und besonders bevorzugt eine magnetische Formgedächtnislegierung (auch bekannt als MSM-Material = Magnetic Shape Memory). Bevorzugt enthält das magnetisch formveränderliche Material dabei Nickel, Mangan und Gallium. Hierdurch kann insbesondere eine besonders einfache Verformung mit einer vorteilhaft großen Stellstrecke realisiert werden.

Das Aktorelement könnte beispielsweise als Hohlkörper, wie beispielsweise als Hohlzylinder, ausgebildet sein. Bevorzugt ist das Aktorelement jedoch als Vollkörper ausgebildet und weist insbesondere eine zumindest im Wesentlichen zylinderförmige, insbesondere kreiszylinderförmige, und/oder vorteilhaft eine zumindest im Wesentlichen streifenförmige, insbesondere quaderförmige, Form und/oder Kontur auf. Unter einem "zumindest im Wesentlichen zylinderförmigen" Objekt soll in diesem Zusammenhang insbesondere ein Objekt verstanden werden, welches von einem zylinderförmigen Referenzobjekt mit einem Volumenanteil von höchstens 20 %, vorzugsweise von höchstens 15 % und besonders bevorzugt von höchstens 10 % abweicht. Entsprechendes soll insbesondere für die Wendung zumindest im Wesentlichen streifenförmig gelten. Hierdurch kann insbesondere ein vorteilhaft kosteneffizientes Aktorelement bereitgestellt werden.

Ferner wird vorgeschlagen, dass das erste Magnetelement und das zweite Magnetelement auf gegenüberliegenden Seiten des Aktorelements angeordnet sind. Vorteilhaft sind das erste Magnetelement und das zweite Magnetelement dabei auf gegenüberliegenden Längsseiten des Aktorelements, welche sich insbesondere in die Längserstreckungsrichtung des Aktorelements erstrecken, angeordnet. Hierdurch kann insbesondere vorteilhaft einfach eine lokale Verformung des Aktorelements erreicht werden.

Des Weiteren wird vorgeschlagen, dass das erste Magnetelement eine Spulenachse aufweist, welche zumindest im Wesentlichen senkrecht zu einer Längserstreckungsrichtung des Aktorelements ausgerichtet ist. In diesem Zusammenhang soll der Ausdruck "zumindest im Wesentlichen senkrecht" insbesondere eine Ausrichtung einer Richtung relativ zu einer Bezugsrichtung definieren, wobei die Richtung und die Bezugsrichtung, insbesondere in einer Ebene betrachtet, einen Winkel insbesondere zwischen 82° und 98°, vorteilhaft zwischen 85° und 95° und besonders bevorzugt zwischen 88° und 92° einschließen. Hierdurch kann insbesondere eine Anzahl an benötigten Spuleneinheiten reduziert werden.

In einer bevorzugten Ausgestaltung der Erfindung wird vorgeschlagen, dass das zweite Magnetelement als Seltenerdmagnet ausgebildet ist. Vorteilhaft besteht das zweite Magnetelement dabei zumindest teilweise, vorzugsweise zu wenigstens einem Großteil und besonders bevorzugt vollständig, aus Neodym-Eisen-Bor, einer Neodym-Eisen-Bor-Legierung, Samarium-Cobalt und/oder einer Samarium-Cobalt-Legierung. Hierdurch kann insbesondere ein vorteilhaft starkes Magnetfeld erzeugt werden.

Ist das zweite Magnetelement beabstandet zu dem Aktorelement angeordnet, kann ein durch die Magnetelemente erzeugtes Magnetfeld vorteilhaft einfach eingestellt werden.

Vorteilhaft ist das zweite Magnetelement dabei in einem Nahbereich des Aktorelements angeordnet.

Das zweite Magnetelement könnte beispielsweise beweglich relativ zu dem Aktorelement sein. Eine vorteilhaft einfache Konstruktion kann jedoch insbesondere erreicht werden, wenn das zweite Magnetelement unbeweglich relativ zu dem Aktorelement ist. Insbesondere ist das zweite Magnetelement dabei stationär ausgebildet. Bevorzugt ist zudem das erste Magnetelement unbeweglich relativ zu dem Aktorelement. Besonders vorteilhaft ist die, insbesondere gesamte, Magneteinheit unbeweglich relativ zu dem Aktorelement.

In einer besonders bevorzugten Ausgestaltung der Erfindung wird vorgeschlagen, dass das zweite Magnetelement eine Magnetisierungsrichtung aufweist, welche zumindest im Wesentlichen parallel zu einer Längserstreckungsrichtung des Aktorelements ausgerichtet ist. Vorteilhaft weist das zweite Magnetelement zudem eine Längserstreckung auf, welche zumindest im Wesentlichen parallel zur Längserstreckungsrichtung des Aktorelements ausgerichtet ist. Hierdurch kann insbesondere eine vorteilhaft kompakte Aktorvorrichtung bereitgestellt werden.

Alternativ wird vorgeschlagen, dass das zweite Magnetelement eine Magnetisierungsrichtung aufweist, welche zumindest im Wesentlichen senkrecht zu einer Längserstreckungsrichtung des Aktorelements ausgerichtet ist. Vorteilhaft weist das zweite Magnetelement in diesem Fall zudem eine Längserstreckung auf, welche zumindest im Wesentlichen senkrecht zur Längserstreckungsrichtung des Aktorelements ausgerichtet ist. Hierdurch kann die Aktorvorrichtung vorteilhaft an insbesondere äußere Bedingungen und/oder Anforderungen angepasst werden.

In einer weiteren Ausgestaltung der Erfindung wird vorgeschlagen, dass die Magneteinheit zumindest ein drittes Magnetelement aufweist, welches dazu vorgesehen ist, mit dem ersten Magnetelement und/oder dem zweiten Magnetelement zusammenzuwirken, um eine lokale Verformung des Aktorelements, vorteilhaft in dem Teilbereich und/oder dem weiteren Teilbereich des Aktorelements, zu bewirken Hierdurch kann insbesondere eine Leistung des ersten Magnetelements und/oder des zweiten Magnetelements reduziert werden, wodurch vorteilhaft Kosten gesenkt und/oder eine Leistungseffizienz verbessert werden kann.

Das dritte Magnetelement könnte beispielsweise als weitere Spuleneinheit ausgebildet sein. In einer bevorzugten Ausgestaltung der Erfindung wird jedoch vorgeschlagen, dass das dritte Magnetelement als Permanentmagnet ausgebildet ist. Vorzugsweise ist das dritte Magnetelement als Seltenerdmagnet ausgebildet und besteht vorteilhaft zumindest teilweise, vorzugsweise zu wenigstens einem Großteil und besonders bevorzugt vollständig, aus Neodym-Eisen-Bor, einer Neodym-Eisen-Bor-Legierung, Samarium-Cobalt und/oder einer Samarium-Cobalt-Legierung. Bevorzugt ist das dritte Magnetelement unbeweglich relativ zu dem Aktorelement. Darüber hinaus sind das erste Magnetelement und das dritte Magnetelement vorteilhaft auf gegenüberliegenden Seiten, vorteilhaft Längsseiten, des Aktorelements angeordnet. Vorteilhaft ist das dritte Magnetelement dabei in einem Nahbereich des Aktorelements und besonders vorteilhaft beabstandet zu dem Aktorelement angeordnet. Darüber hinaus könnte das dritte Magnetelement eine Magnetisierungsrichtung und/oder Längserstreckung aufweisen, welche zumindest im Wesentlichen senkrecht zur Längserstreckungsrichtung des Aktorelements ausgerichtet ist. Vorteilhaft weist das dritte Magnetelement jedoch eine Magnetisierungsrichtung auf, welche zumindest im Wesentlichen parallel zur Längserstreckungsrichtung des Aktorelements ausgerichtet ist. Zudem weist das dritte Magnetelement bevorzugt eine Längserstreckung auf, welche zumindest im Wesentlichen parallel zur Längserstreckungsrichtung des Aktorelements ausgerichtet ist. Hierdurch kann insbesondere eine Bauraumeffizienz optimiert werden.

Vorteilhaft wird ferner vorgeschlagen, dass das dritte Magnetelement zumindest im Wesentlichen identisch zu dem zweiten Magnetelement ist. Unter der Wendung "zumindest im Wesentlichen identisch" soll dabei insbesondere abgesehen von Fertigungstoleranzen und/oder im Rahmen fertigungstechnischer Möglichkeiten und/oder im Rahmen standardisierter Toleranzen identisch verstanden werden. Hierdurch können insbesondere Kosten reduziert werden.

Eine nahezu bauraumneutrale Ausgestaltung kann insbesondere erreicht werden, wenn das zweite Magnetelement und das dritte Magnetelement auf einer selben Seite, insbesondere Längsseite, des Aktorelements angeordnet sind.

Darüber hinaus wird vorgeschlagen, dass die Magneteinheit zumindest ein Flussleitmittel aufweist, welches wenigstens das Aktorelement und vorteilhaft das erste Magnetelement, das zweite Magnetelement und/oder das dritte Magnetelement, zumindest im Wesentlichen komplett umgreift. Bevorzugt erzeugt das Flussleitmittel dabei zusammen mit dem zweiten Magnetelement und/oder dem dritten Magnetelement einen Magnetkreis. Vorteilhaft ist das Flussleitmittel ferner zumindest teilweise, vorzugsweise zu wenigstens einem Großteil und besonders bevorzugt vollständig, als Ferritelement, insbesondere Eisenelement, ausgebildet. Unter der Wendung "zumindest im Wesentlichen komplett" soll dabei insbesondere zu zumindest 85 %, vorteilhaft zu zumindest 90 %, vorzugsweise zu zumindest 90 % und besonders bevorzugt zu zumindest 95 % verstanden werden. Hierdurch können insbesondere eine vorteilhafte Führung des Magnetfelds und insbesondere eine vorteilhaft exakte Positionierung und/oder Einstellung der lokalen Verformung erreicht werden.

Des Weiteren wird vorgeschlagen, dass die Magneteinheit zumindest einen Flusskonzentrator aufweist, welcher dazu vorgesehen ist, ein auf das Aktorelement einwirkendes Magnetfeld, insbesondere der Magnetelemente, zu erhöhen. Vorteilhaft ist der Flusskonzentrator dabei einem der Magnetelemente zugeordnet und insbesondere in einem montierten Zustand zumindest teilweise zwischen dem dem Flusskonzentrator zugeordneten Magnetelement und dem Aktorelement angeordnet. Hierdurch kann insbesondere ein auf das Aktorelement einwirkendes Magnetfeld erhöht werden, wodurch vorteilhaft eine Anzahl an Magnetelementen und/oder eine Größe der Magnetelemente reduziert werden kann. Somit kann insbesondere eine vorteilhaft bauraumeffiziente Aktorvorrichtung bereitgestellt werden.

In einer besonders bevorzugten Ausgestaltung der Erfindung wird vorgeschlagen, dass die Magneteinheit höchstens zwei als Spuleneinheiten ausgebildete Magnetelemente umfasst. Bevorzugt umfasst die Magneteinheit genau ein als Spuleneinheit ausgebildetes Magnetelement, insbesondere das erste Magnetelement. Hierdurch kann insbesondere eine Wärmeentwicklung besonders vorteilhaft minimiert werden.

Zudem geht die Erfindung aus von einem Verfahren mit einer Aktorvorrichtung, wobei die Aktorvorrichtung zumindest ein Aktorelement aufweist, welches zumindest teilweise, vorzugsweise zu wenigstens einem Großteil und besonders bevorzugt vollständig, aus einem magnetisch formveränderlichen Material besteht, und eine Magneteinheit aufweist, welche zumindest ein als Spuleneinheit ausgebildetes erstes Magnetelement und zumindest ein als Permanentmagnet ausgebildetes zweites Magnetelement umfasst.

Es wird vorgeschlagen, dass das Aktorelement zumindest mittels Zusammenwirken des ersten Magnetelements und des zweiten Magnetelements lokal in einem Teilbereich, vorteilhaft einem Randbereich, verformt wird. Hierdurch kann insbesondere eine Effizienz, insbesondere eine Energieeffizienz, eine Bauteileeffizienz, eine Bauraumeffizienz und/oder eine Kosteneffizienz, verbessert werden. Darüber hinaus kann vorteilhaft eine Wärmeentwicklung, wie beispielsweise bei einer ausschließlichen Verwendung von Elektromagneten, reduziert werden. Zudem kann vorteilhaft eine besonders kompakte Aktorvorrichtung bereitgestellt werden. Darüber hinaus kann vorteilhaft eine Ansteuerung, insbesondere der Magneteinheit, vereinfacht werden. Ferner kann eine vorteilhaft geräuscharme Aktorvorrichtung bereitgestellt werden.

Die Aktorvorrichtung und das Verfahren mit der Aktorvorrichtung sollen hierbei nicht auf die oben beschriebene Anwendung und Ausführungsform beschränkt sein. Insbesondere kann die Aktorvorrichtung und das Verfahren mit der Aktorvorrichtung zu einer Erfüllung einer hierin beschriebenen Funktionsweise eine von einer hierin genannten Anzahl von einzelnen Elementen, Bauteilen und Einheiten abweichende Anzahl aufweisen.

### Zeichnungen

Weitere Vorteile ergeben sich aus der folgenden Zeichnungsbeschreibung. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1a-b: ein Aktor mit einer Aktorvorrichtung in einer schematischen Seitenansicht,
- Fig. 2a-b: der Aktor mit der Aktorvorrichtung in einem ersten Betriebszustand,
- Fig. 3a-b: der Aktor mit der Aktorvorrichtung in einem zweiten Betriebszustand,
- Fig. 4: ein weiterer Aktor mit einer weiteren Aktorvorrichtung in einer schematischen Seitenansicht,
- Fig. 5a-b: ein weiterer Aktor mit einer weiteren Aktorvorrichtung in einer schematischen Seitenansicht,
- Fig. 6a-b: der weitere Aktor mit der weiteren Aktorvorrichtung aus Figur 5a-b in einem ersten Betriebszustand,
- Fig. 7a-b: der weitere Aktor mit der weiteren Aktorvorrichtung aus Figur 5a-b in einem zweiten Betriebszustand,
- Fig. 8: eine Fluidpumpe mit einer weiteren Aktorvorrichtung in einer schematischen Seitenansicht,
- Fig. 9: die Fluidpumpe mit der weiteren Aktorvorrichtung aus Figur 8 in einem ersten Betriebszustand,
- Fig. 10: die Fluidpumpe mit der weiteren Aktorvorrichtung aus Figur 8 in einem zweiten Betriebszustand und
- Fig. 11: ein Positionierungssystem mit zumindest einer weiteren Aktorvorrichtung in einer schematischen Seitenansicht.

### Beschreibung der Ausführungsbeispiele

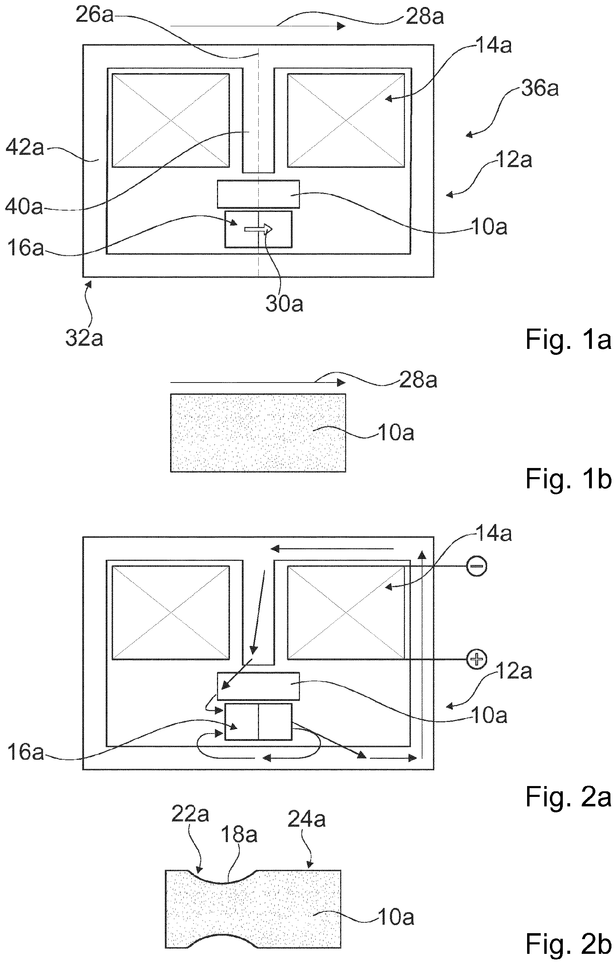

Die Figuren 1a und 1b zeigen einen beispielhaften Aktor 36a mit einer Aktorvorrichtung in einer schematischen Ansicht. Die Aktorvorrichtung umfasst zumindest ein Aktorelement 10a (vgl. auch Figur 1b). Im vorliegenden Fall umfasst die Aktorvorrichtung genau ein Aktorelement 10a. Grundsätzlich könnte eine Aktorvorrichtung jedoch auch eine andere Anzahl an Aktorelementen aufweisen, wie beispielsweise zumindest zwei Aktorelemente und/oder zumindest drei Aktorelemente.

Das Aktorelement 10a ist einstückig ausgebildet. Das Aktorelement 10a ist als Vollkörper ausgebildet. Das Aktorelement 10a ist zumindest im Wesentlichen streifenförmig und/oder quaderförmig ausgebildet. Das Aktorelement 10a ist länglich ausgebildet und weist eine, insbesondere in den Figuren 1a und 1b horizontal angeordnete, Längserstreckung auf. Die Längserstreckung des Aktorelements 10a definiert dabei eine Längserstreckungsrichtung 28a des Aktorelements 10a. Vorzugsweise beträgt eine Längserstreckung des Aktorelements 10a zumindest 5 mm, vorteilhaft zumindest 7,5 mm und besonders bevorzugt zumindest 10 mm und/oder höchstens 60 mm, vorteilhaft höchstens 40 mm und besonders bevorzugt höchstens 20 mm. Eine, insbesondere in den Figuren 1a und 1b vertikal angeordnete, Quererstreckung des Aktorelements 10a beträgt vorzugsweise zumindest 0,5 mm, vorteilhaft zumindest 1 mm und besonders bevorzugt zumindest 2 mm und/oder höchstens 20 mm, vorteilhaft höchstens 10 mm und besonders bevorzugt höchstens 5 mm. Ferner beträgt eine Höhenerstreckung des Aktorelements 10a vorzugsweise höchstens 1 mm.

Darüber hinaus ist das Aktorelement 10a formveränderlich ausgebildet. Das Aktorelement 10a besteht aus einem magnetisch formveränderlichen Material. Das Aktorelement 10a besteht aus einem magnetisch formveränderlichen Formgedächtnismaterial. Im vorliegenden Fall besteht das Aktorelement 10a aus einer magnetischen Formgedächtnislegierung. Die magnetische Formgedächtnislegierung enthält Nickel, Mangan und Gallium. Das Aktorelement 10a besteht dabei aus einer Nickel-Mangan-Gallium Legierung. Das Aktorelement 10a ist ferner als Einkristall ausgebildet. Alternativ könnte ein Aktorelement jedoch auch aus einer Nickel-Mangan-Gallium-haltigen Legierung, einer Eisen-Palladium-Legierung und/oder einer Eisen-Palladium-haltigen Legierung bestehen. Zudem könnte ein Aktorelement auch als Schaum, als Polykristall und/oder als Kompositstruktur ausgebildet sein, wobei in letzterem Fall Nickel-, Mangan- und Gallium-Bestandteile in einer Matrix eingebettet sein können. Ferner könnte ein Aktorelement prinzipiell auch aus einem magnetostriktiven Material bestehen.

Bei dem verwendeten magnetisch formveränderlichen Formgedächtnismaterial handelt es sich um ein magnetisch aktives Material. Dieses Material weist die Eigenschaft auf, dass als Reaktion auf ein angelegtes Magnetfeld, wie beispielsweise durch ein als Spule und/oder Permanentmagnet ausgebildetes Magnetelement, mit einer definierten minimalen Feldstärke und einer definierten Richtung eine Verformung und/oder Formveränderung des Aktorelements 10a, im vorliegenden Fall in zumindest einem Betriebszustand eine lokale Verformung in Richtung der Quererstreckung des Aktorelements 10a und eine damit korrelierte Expansionsbewegung in Längserstreckungsrichtung 28a des Aktorelements 10a, stattfindet. Im vorliegenden Fall ist das Aktorelement 10a somit mittels eines Magnetfelds beinflussbar und insbesondere verformbar.

Ferner umfasst die Aktorvorrichtung eine Magneteinheit 12a. Die Magneteinheit 12a ist in einem Nahbereich des Aktorelements 10a angeordnet. Die Magneteinheit 12a ist unbeweglich relativ zu dem Aktorelement 10a. Die Magneteinheit 12a ist dazu vorgesehen, ein auf das Aktorelement 10a einwirkendes Magnetfeld bereitzustellen. Die Magneteinheit 12a ist dazu vorgesehen, ein Magnetfeld bereitzustellen, welches zumindest im Wesentlichen senkrecht zur Längserstreckungsrichtung 28a des Aktorelements 10a ausgerichtet ist. Die Magneteinheit 12a ist dazu vorgesehen, ein veränderliches Magnetfeld bereitzustellen. Die Magneteinheit 12a ist dazu vorgesehen, eine Verformung des Aktorelements 10a, insbesondere mittels des Magnetfelds, zu beeinflussen.

Dazu umfasst die Magneteinheit 12a zumindest zwei Magnetelemente 14a, 16a. Im vorliegenden Fall umfasst die Magneteinheit 12a genau zwei Magnetelemente 14a, 16a. Die Magnetelemente 14a, 16a sind separat voneinander ausgebildet. Die Magnetelemente 14a, 16a sind verschieden ausgebildet. Die Magnetelemente 14a, 16a sind auf verschiedenen Seiten des Aktorelements 10a angeordnet. Die Magnetelemente 14a, 16a sind dabei auf gegenüberliegenden Seiten des Aktorelements 10a angeordnet. Im vorliegenden Fall sind die Magnetelemente 14a, 16a auf gegenüberliegenden Längsseiten des Aktorelements 10a angeordnet.

Ein erstes Magnetelement 14a der Magnetelemente 14a, 16a ist als Spuleneinheit ausgebildet. Das erste Magnetelement 14a ist dabei als einzelne Spule, insbesondere als Elektromagnet, ausgebildet. Das erste Magnetelement 14a ist aktiv ansteuerbar und weist eine Wirkverbindung mit einer Versorgungselektronik (nicht dargestellt) der Aktorvorrichtung auf. Das erste Magnetelement 14a ist unbeweglich relativ zu dem Aktorelement 10a. Das erste Magnetelement 14a ist in einem Nahbereich des Aktorelements 10a angeordnet. Das erste Magnetelement 14a ist beabstandet zu dem Aktorelement 10a angeordnet. Das erste Magnetelement 14a ist derart angeordnet, dass mittels des ersten Magnetelements 14a erzeugte Magnetfeldlinien das Aktorelements 10a zumindest im Wesentlichen senkrecht bezüglich der Längserstreckung des Aktorelements 10a schneiden und/oder durchdringen. Das erste Magnetelement 14a weist dabei eine Spulenachse 26a auf, welche senkrecht zu der Längserstreckungsrichtung 28a des Aktorelements 10a ausgerichtet ist.

Ein zweites Magnetelement 16a der Magnetelemente 14a, 16a ist als Permanentmagnet ausgebildet. Demnach umfasst die Magneteinheit 12a im vorliegenden Fall höchstens zwei als Spuleneinheiten ausgebildete Magnetelemente. Das zweite Magnetelement 16a ist einstückig ausgebildet. Das zweite Magnetelement 16a ist zumindest im Wesentlichen quaderförmig ausgebildet.

Darüber hinaus ist das zweite Magnetelement 16a passiv ausgebildet und insbesondere frei von einer aktiven Ansteuermöglichkeit. Das zweite Magnetelement 16a besteht aus einem Permanentmagnetwerkstoff. Der Permanentmagnetwerkstoff ist ein hartmagnetischer Werkstoff, welcher insbesondere eine Koerzitivfeldstärke von zumindest 1 kA/m und vorteilhaft zumindest 50 kA/m aufweist. Das zweite Magnetelement 16a ist dabei als Seltenerdmagnet ausgebildet und weist insbesondere nach einer anfänglichen Magnetisierung eine Remanenz auf. Eine Remanenzflussdichte des zweiten Magnetelements 16a beträgt vorteilhaft zumindest 0,4 T. Im vorliegenden Fall besteht das zweite Magnetelement 16a insbesondere aus Neodym-Eisen-Bor.

Das zweite Magnetelement 16a ist unbeweglich relativ zu dem Aktorelement 10a. Das zweite Magnetelement 16a ist in einem Nahbereich des Aktorelements 10a angeordnet. Das zweite Magnetelement 16a ist beabstandet zu dem Aktorelement 10a angeordnet. Das zweite Magnetelement 16a ist ferner länglich ausgebildet und weist eine, insbesondere in den Figuren 1a und 1b horizontal angeordnete, Längserstreckung auf. Das zweite Magnetelement 16a weist dabei eine Längserstreckung auf, welche parallel zur Längserstreckungsrichtung 28a des Aktorelements 10a ausgerichtet ist. Zudem weist das zweite Magnetelement 16a eine Magnetisierungsrichtung 30a auf, welche parallel zur Längserstreckungsrichtung 28a des Aktorelements 10a ausgerichtet ist. Das zweite Magnetelement 16a ist derart angeordnet, dass Magnetfeldlinien des zweiten Magnetelements 16a das Aktorelement 10a zumindest im Wesentlichen parallel bezüglich der Längserstreckung des Aktorelements 10a schneiden und/oder durchdringen.

Das erste Magnetelement 14a und das zweite Magnetelement 16a sind derart angeordnet, dass diese zusammenwirken. Das erste Magnetelement 14a und das zweite Magnetelement 16a sind dabei derart angeordnet, dass sich Einzelmagnetfelder des ersten Magnetelements 14a und des zweiten Magnetelements 16a gegenseitig überlagern und insbesondere in einem Bereich des Aktorelements 10a ein gemeinsames und/oder resultierendes Magnetfeld erzeugen. Prinzipiell könnte eine Magneteinheit jedoch auch eine andere Anzahl an, insbesondere zusammenwirkenden, Magnetelementen aufweisen, wie beispielsweise drei Magnetelemente und/oder vier Magnetelemente. Darüber hinaus könnte ein als Spuleneinheit ausgebildetes Magnetelement und/oder ein als Permanentmagnet ausgebildetes Magnetelement grundsätzlich auch beweglich relativ zu einem Aktorelement gelagert sein.

Zudem umfasst die Magneteinheit 12a zumindest ein Flussleitmittel 32a. Im vorliegenden Fall umfasst die Magneteinheit 12a genau ein Flussleitmittel 32a. Das Flussleitmittel 32a ist einstückig ausgebildet. Das Flussleitmittel 32a ist als Ferritelement, im vorliegenden Fall insbesondere als Eisenelement, ausgebildet. Das Flussleitmittel 32a bildet zusammen mit dem zweiten Magnetelement 16a einen Magnetkreis.

Das Flussleitmittel 32a weist einen ersten Flussleitmittelabschnitt 40a auf. Der erste Flussleitmittelabschnitt 40a entspricht einem Magnetkern, insbesondere des ersten Magnetelements 14a. Der erste Flussleitmittelabschnitt 40a weist eine Längserstreckung auf, welche parallel zu der Spulenachse 26a ausgerichtet ist. Der erste Flussleitmittelabschnitt 40a ist dabei in einem zentralen Bereich des ersten Magnetelements 14a angeordnet.

Ferner umfasst das Flussleitmittel 32a einen zweiten Flussleitmittelabschnitt 42a. Der zweite Flussleitmittelabschnitt 42a entspricht einem, im vorliegenden Fall insbesondere geschlossenen, magnetischen Rückschluss. Der zweite Flussleitmittelabschnitt 42a umgreift das Aktorelement 10a komplett. Ferner umgreift der zweite Flussleitmittelabschnitt 42a das erste Magnetelement 14a komplett. Darüber hinaus umgreift der zweite Flussleitmittelabschnitt 42a das zweite Magnetelement 16a komplett.

Das Flussleitmittel 32a ist dazu vorgesehen, Magnetfeldlinien der Magneteinheit 12a, insbesondere des ersten Magnetelements 14a und des zweiten Magnetelements 16a, zumindest teilweise zu leiten und/oder zu führen, insbesondere um eine definierte Verformung des Aktorelements 10a zu erreichen. Alternativ könnte ein Flussleitmittel auch mehrteilig ausgebildet sein. Zudem ist prinzipiell auch denkbar, auf einen ersten Flussleitmittelabschnitt und/oder einen zweiten Flussleitmittelabschnitt zu verzichten. Darüber hinaus ist denkbar, ein Flussleitmittel, insbesondere einen ersten Flussleitmittelabschnitt und/oder einen zweiten Flussleitmittelabschnitt, mit zumindest einem Spalt, vorteilhaft Luftspalt, zu versehen.

Eine Funktionsweise der Aktorvorrichtung wird nun im Folgenden mit Verweis auf die Figuren 2a bis 3b erläutert.

Im vorliegenden Fall ist die Magneteinheit 12a zumindest dazu vorgesehen, mittels eines Magnetfelds eine, insbesondere rein, lokale Verformung 18a, 20a des Aktorelements 10a in einem ersten Teilbereich 22a des Aktorelements 10a und in einem von dem ersten Teilbereich 22a verschiedenen zweiten Teilbereich 24a des Aktorelements 10a zu bewirken.

Die Teilbereiche 22a, 24a sind dabei jeweils Teilbereiche einer Längsseite, im vorliegenden Fall insbesondere derselben Längsseite, des Aktorelements 10a. Ferner entspricht der erste Teilbereich 22a einem ersten Randbereich des Aktorelements 10a, welcher sich insbesondere über höchstens 50 % einer gesamten Längserstreckung des Aktorelements 10a erstreckt. Der zweite Teilbereich 24a entspricht einem zweiten Randbereich des Aktorelements 10a, welcher sich insbesondere über höchstens 50 % einer gesamten Längserstreckung des Aktorelements 10a erstreckt. Der zweite Teilbereich 24a ist dabei dem ersten Teilbereich 22a, insbesondere bezüglich der Längserstreckungsrichtung 28a des Aktorelements 10a, gegenüberliegend.

Im vorliegenden Fall sind das erste Magnetelement 14a und das zweite Magnetelement 16a dazu vorgesehen, in zumindest einem ersten Betriebszustand zusammenzuwirken, um eine lokale Verformung 18a des Aktorelements 10a in dem ersten Teilbereich 22a des Aktorelements 10a zu bewirken.

Die Figuren 2a und 2b zeigen die Aktorvorrichtung in dem ersten Betriebszustand. Figur 2a zeigt dabei insbesondere einen Verlauf von Magnetfeldlinien der Magneteinheit 12a, während in Figur 2b eine Verformung des Aktorelements 10a dargestellt ist. In dem ersten Betriebszustand wird das erste Magnetelement 14a mittels der Versorgungselektronik mit einem Strom beaufschlagt, wodurch insbesondere zusammen mit dem zweiten Magnetelement 16a ein gemeinsames erstes Magnetfeld bewirkt wird. Als Folge verformt sich das Aktorelement 10a lokal in dem ersten Teilbereich 22a. Zudem ist das Aktorelement 10a in einem von dem ersten Teilbereich 22a verschiedenen Teilbereich und insbesondere in dem zweiten Teilbereich 24a unverformt. Die lokale Verformung 18a in dem ersten Teilbereich 22a entspricht dabei einer lokalen Vertiefung und/oder Mulde. Die lokale Verformung 18a in dem ersten Teilbereich 22a weist eine zumindest im Wesentlichen halbellipsenförmige Kontur auf. Die lokale Verformung 18a in dem ersten Teilbereich 22a weist eine, insbesondere parallel zur Längserstreckungsrichtung 28a des Aktorelements 10a angeordnete, Längserstreckung auf.

Zudem sind das erste Magnetelement 14a und das zweite Magnetelement 16a dazu vorgesehen, in zumindest einem zweiten Betriebszustand zusammenzuwirken, um eine lokale Verformung 20a des Aktorelements 10a in dem zweiten Teilbereich 24a des Aktorelements 10a zu bewirken.

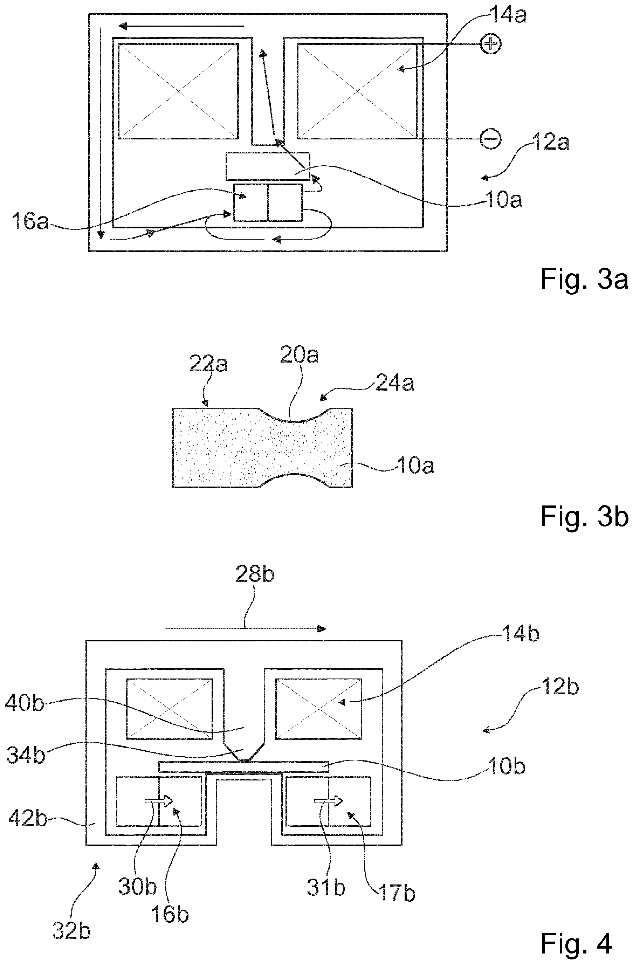

Die Figuren 3a und 3b zeigen die Aktorvorrichtung in dem zweiten Betriebszustand. Figur 3a zeigt dabei insbesondere einen Verlauf von Magnetfeldlinien der Magneteinheit 12a, während in Figur 3b eine Verformung des Aktorelements 10a dargestellt ist. In dem zweiten Betriebszustand wird das erste Magnetelement 14a mittels der Versorgungselektronik mit einem zu dem Strom entgegengesetzten Strom, insbesondere Gegenstrom beaufschlagt, wodurch insbesondere zusammen mit dem zweiten Magnetelement 16a ein gemeinsames zweites Magnetfeld bewirkt wird. Als Folge verformt sich das Aktorelement 10a lokal in dem zweiten Teilbereich 24a. Zudem ist das Aktorelement 10a in einem von dem zweiten Teilbereich 24a verschiedenen Teilbereich und insbesondere in dem ersten Teilbereich 22a unverformt. Die lokale Verformung 20a in dem zweiten Teilbereich 24a entspricht dabei einer lokalen Vertiefung und/oder Mulde. Die lokale Verformung 20a in dem zweiten Teilbereich 24a weist eine zumindest im Wesentlichen halbellipsenförmige Kontur auf. Die lokale Verformung 20a in dem zweiten Teilbereich 24a weist eine, insbesondere parallel zur Längserstreckungsrichtung 28a des Aktorelements 10a angeordnete, Längserstreckung auf. Die lokale Verformung 20a in dem zweiten Teilbereich 24a entspricht zumindest im Wesentlichen der lokalen Verformung 18a in dem ersten Teilbereich 22a. Prinzipiell könnte eine Verformung des Aktorelements in zumindest einem Teilbereich auch einer lokalen Erhöhung entsprechen. Darüber hinaus ist denkbar, dass eine Magneteinheit lediglich dazu vorgesehen sein kann, in genau einem Teilbereich eines Aktorelements eine lokale Verformung zu erzeugen. Auch könnte eine Magneteinheit dazu vorgesehen sein, in zumindest drei und/oder zumindest vier Teilbereichen eines Aktorelements eine lokale Verformung zu erzeugen.

Darüber hinaus sind das erste Magnetelement 14a und das zweite Magnetelement 16a im vorliegenden Fall dazu vorgesehen, insbesondere mittels einer entsprechenden wechselförmigen Ansteuerung des ersten Magnetelements 14a, insbesondere mittels der Versorgungselektronik, ein veränderliches Magnetfeld zu erzeugen, um eine Bewegung der lokalen Verformung 18a, 20a von dem ersten Teilbereich 22a zu dem zweiten Teilbereich 24a zu bewirken. Dabei sind das erste Magnetelement 14a und das zweite Magnetelement 16a dazu vorgesehen, eine zumindest im Wesentlichen gleichförmige Bewegung der lokalen Verformung 18a, 20a von dem ersten Teilbereich 22a zu dem zweiten Teilbereich 24a zu erzeugen, wodurch beispielsweise eine vorteilhafte Pumpbewegung und/oder variabel einstellbare Bewegung erreicht werden kann. Die Versorgungselektronik ist in diesem Fall dazu vorgesehen, zur Erzeugung des veränderlichen Magnetfelds einen Strom mit einem rechteckförmigen und/oder vorteilhaft sinusförmigen Profil bereitzustellen.

In den Figuren 4 bis 11 sind weitere Ausführungsbeispiele der Erfindung gezeigt. Die nachfolgenden Beschreibungen und die Zeichnungen beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnungen und/oder die Beschreibung der anderen Ausführungsbeispiele, insbesondere der Figuren 1 bis 3b, verwiesen werden kann. Zur Unterscheidung der Ausführungsbeispiele ist der Buchstabe a den Bezugszeichen des Ausführungsbeispiels in den Figuren 1 bis 3b nachgestellt. In den Ausführungsbeispielen der Figuren 4 bis 11 ist der Buchstabe a durch die Buchstaben b bis e ersetzt.

In Figur 4 ist ein weiteres Ausführungsbeispiel der Erfindung gezeigt. Dem Ausführungsbeispiel der Figur 4 ist der Buchstabe b nachgestellt. Das weitere Ausführungsbeispiel der Figur 4 unterscheidet sich von dem vorherigen Ausführungsbeispiel zumindest im Wesentlichen durch eine Ausgestaltung einer Magneteinheit 12b.

Im vorliegenden Fall umfasst die Magneteinheit 12b drei Magnetelemente 14b, 16b, 17b, welche dazu vorgesehen sind, zusammenzuwirken, um eine lokale Verformung 18b, 20b eines Aktorelements 10b zu bewirken. Die Magnetelemente 14b, 16b, 17b sind dabei dazu vorgesehen, in zumindest einem ersten Betriebszustand zusammenzuwirken, um eine lokale Verformung 18b des Aktorelements 10b in einem ersten Teilbereich 22b des Aktorelements 10a zu bewirken. Zudem sind die Magnetelemente 14b, 16b, 17b dazu vorgesehen, in zumindest einem zweiten Betriebszustand zusammenzuwirken, um eine lokale Verformung 20b des Aktorelements 10b in einem zweiten Teilbereich 24b des Aktorelements 10a zu bewirken. Darüber hinaus können die Magnetelemente 14b, 16b, 17b dazu vorgesehen sein, ein veränderliches Magnetfeld zu erzeugen, um eine Bewegung der lokalen Verformung 18b, 20b von dem ersten Teilbereich 22b zu dem zweiten Teilbereich 24b zu bewirken.

Ein erstes Magnetelement 14b der Magnetelemente 14b, 16b, 17b entspricht dabei zumindest im Wesentlichen einem ersten Magnetelement 14a des vorherigen Ausführungsbeispiels.

Ein zweites Magnetelement 16b und ein drittes Magnetelement 17b der Magnetelemente 14b, 16b, 17b sind jeweils als Permanentmagnet ausgebildet. Das zweite Magnetelement 16b und das dritte Magnetelement 17b sind separat voneinander ausgebildet. Das zweite Magnetelement 16b und das dritte Magnetelement 17b sind zumindest im Wesentlichen identisch zueinander ausgebildet. Das zweite Magnetelement 16b und das dritte Magnetelement 17b sind jeweils einstückig ausgebildet. Das zweite Magnetelement 16b und das dritte Magnetelement 17b sind jeweils zumindest im Wesentlichen quaderförmig ausgebildet.

Darüber hinaus sind das zweite Magnetelement 16b und das dritte Magnetelement 17b passiv ausgebildet und insbesondere frei von einer aktiven Ansteuermöglichkeit. Das zweite Magnetelement 16b und das dritte Magnetelement 17b bestehen jeweils aus einem Permanentmagnetwerkstoff. Im vorliegenden Fall bestehen das zweite Magnetelement 16b und das dritte Magnetelement 17b aus demselben Permanentmagnetwerkstoff. Der Permanentmagnetwerkstoff ist ein hartmagnetischer Werkstoff, welcher insbesondere eine Koerzitivfeldstärke von zumindest 1 kA/m und vorteilhaft zumindest 50 kA/m aufweist. Das zweite Magnetelement 16b und das dritte Magnetelement 17b sind dabei jeweils als Seltenerdmagnet ausgebildet und weisen insbesondere nach einer anfänglichen Magnetisierung eine Remanenz auf. Eine Remanenzflussdichte beträgt vorteilhaft zumindest 0,4 T.

Das zweite Magnetelement 16b und das dritte Magnetelement 17b sind jeweils unbeweglich relativ zu dem Aktorelement 10b. Das zweite Magnetelement 16b und das dritte Magnetelement 17b sind jeweils in einem Nahbereich des Aktorelements 10b angeordnet. Das zweite Magnetelement 16b und das dritte Magnetelement 17b sind auf einer selben Seite des Aktorelements 10b angeordnet. Das zweite Magnetelement 16b und das dritte Magnetelement 17b sind jeweils beabstandet zu dem Aktorelement 10b angeordnet. Ein Abstand zwischen dem zweiten Magnetelement 16b und dem Aktorelement 10b ist dabei identisch zu einem Abstand zwischen dem dritten Magnetelement 17b und dem Aktorelement 10b. Zudem sind das zweite Magnetelement 16b und das dritte Magnetelement 17b beabstandet zueinander. Das zweite Magnetelement 16b und das dritte Magnetelement 17b sind in Längserstreckung des Aktorelements 10b versetzt zueinander.

Das zweite Magnetelement 16b und das dritte Magnetelement 17b sind ferner jeweils länglich ausgebildet und weisen eine, insbesondere in der Figur 4 horizontal angeordnete, Längserstreckung auf. Das zweite Magnetelement 16b und das dritte Magnetelement 17b weisen dabei jeweils eine Längserstreckung auf, welche parallel zu einer Längserstreckungsrichtung 28b des Aktorelements 10b ausgerichtet ist. Zudem weisen das zweite Magnetelement 16b und das dritte Magnetelement 17b jeweils eine Magnetisierungsrichtung 30b, 31b auf, welche parallel zur Längserstreckungsrichtung 28b des Aktorelements 10b ausgerichtet ist. Ferner ist eine Magnetisierungsrichtung 30b des zweiten Magnetelements 16b identisch zu einer weiteren Magnetisierungsrichtung 31b des dritten Magnetelements 17b. Das zweite Magnetelement 16b und das dritte Magnetelement 17b sind derart angeordnet, dass Magnetfeldlinien des zweiten Magnetelements 16b und des dritten Magnetelements 17b das Aktorelement 10b zumindest im Wesentlichen parallel bezüglich der Längserstreckung des Aktorelements 10b schneiden und/oder durchdringen.

Das erste Magnetelement 14b, das zweite Magnetelement 16b und das dritte Magnetelement 17b sind derart angeordnet, dass sich Einzelmagnetfelder der Magnetelemente 14b, 16b, 17b gegenseitig überlagern und insbesondere in einem Bereich des Aktorelements 10b ein gemeinsames und/oder resultierendes Magnetfeld erzeugen. Alternativ ist denkbar, ein zweites Magnetelement und ein drittes Magnetelement verschieden auszubilden und/oder in einer abweichenden Konfiguration anzuordnen.

Darüber hinaus umfasst die Magneteinheit 12b zumindest einen Flusskonzentrator 34b. Im vorliegenden Fall umfasst die Magneteinheit 12b genau einen Flusskonzentrator 34b. Der Flusskonzentrator 34b weist eine zumindest im Wesentlichen konische Form und/oder Kontur auf. Der Flusskonzentrator 34b ist als Ferritelement, im vorliegenden Fall insbesondere als Eisenelement, ausgebildet. Der Flusskonzentrator 34b ist Teil eines Flussleitmittels 32b der Magneteinheit 12b. Der Flusskonzentrator 34b ist dabei einstückig mit dem Flussleitmittel 32b ausgebildet. Der Flusskonzentrator 34b ist im vorliegenden Fall einstückig mit einem ersten Flussleitmittelabschnitt 40b des Flussleitmittels 32b ausgebildet. Der Flusskonzentrator 34b ist auf einer dem Aktorelement 10b zugewandten Seite des ersten Flussleitmittelabschnitts 40b angeordnet. Der Flusskonzentrator 34b ist dem ersten Magnetelement 14b zugeordnet. Der Flusskonzentrator 34b ist in einem montierten Zustand zwischen dem ersten Magnetelement 14b und dem Aktorelement 10b angeordnet. Der Flusskonzentrator 34b ist dazu vorgesehen, ein auf das Aktorelement 10b einwirkendes Magnetfeld, insbesondere des ersten Magnetelements 14b, zu erhöhen. Alternativ könnte eine Magneteinheit auch eine andere Anzahl an Flusskonzentratoren aufweisen, wie beispielsweise zumindest zwei und/oder zumindest vier Flusskonzentratoren, welche insbesondere auf verschiedenen Seiten eines Aktorelements angeordnet sein können. Zudem ist denkbar, Flusskonzentratoren separat von einem Flussleitmittel auszubilden.

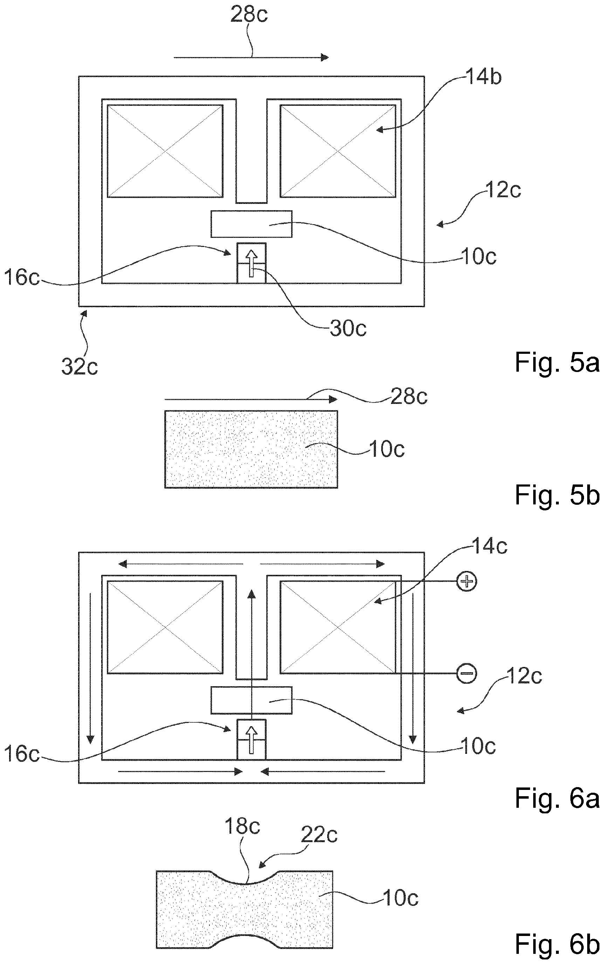

Die Figuren 5a bis 7b zeigen ein weiteres Ausführungsbeispiel der Erfindung. Dem Ausführungsbeispiel der Figuren 5a bis 7b ist der Buchstabe c nachgestellt. Das weitere Ausführungsbeispiel der Figuren 5a bis 7b unterscheidet sich von den vorherigen Ausführungsbeispielen zumindest im Wesentlichen durch eine Ausrichtung eines zweiten Magnetelements 16c einer Magneteinheit 12c.

Das zweite Magnetelement 16c ist länglich ausgebildet und weist eine, insbesondere in den Figuren 5a bis 7b vertikal angeordnete, Längserstreckung auf. Das zweite Magnetelement 16c weist dabei eine Längserstreckung auf, welche senkrecht zu einer Längserstreckungsrichtung 28c eines Aktorelements 10c ausgerichtet ist. Zudem weist das zweite Magnetelement 16c eine Magnetisierungsrichtung 30c auf, welche senkrecht zur Längserstreckungsrichtung 28c des Aktorelements 10c ausgerichtet ist. Das zweite Magnetelement 16c ist derart angeordnet, dass Magnetfeldlinien des zweiten Magnetelements 16c das Aktorelement 10c zumindest im Wesentlichen senkrecht bezüglich der Längserstreckung des Aktorelements 10c schneiden und/oder durchdringen. Abgesehen davon entspricht das zweite Magnetelement 16c dem zweiten Magnetelement 16a des ersten Ausführungsbeispiels.

Aufgrund der Anordnung des zweiten Magnetelements 16c ist die Magneteinheit 12c dazu vorgesehen, mittels eines Magnetfeldes eine, insbesondere rein, lokale Verformung 18c, 20c, 21c des Aktorelements 10c in drei verschiedenen Teilbereichen 22c, 24c, 25c des Aktorelements 10c zu bewirken, insbesondere in einem ersten Teilbereich 22c des Aktorelements 10c, in einem von dem ersten Teilbereich 22c verschiedenen zweiten Teilbereich 24c des Aktorelements 10c und in einem von dem ersten Teilbereich 22c und dem zweiten Teilbereich 24c verschiedenen dritten Teilbereich 25c des Aktorelements 10c.

Der erste Teilbereich 22c entspricht dabei einem zentralen Bereich des Aktorelements 10c. Der zweite Teilbereich 24c entspricht einem ersten Randbereich des Aktorelements 10c. Der dritte Teilbereich 25c entspricht einem zweiten Randbereich des Aktorelements 10c. Der dritte Teilbereich 25c ist dabei dem zweiten Teilbereich 24c, insbesondere bezüglich der Längserstreckungsrichtung 28c des Aktorelements 10c, gegenüberliegend.

Im vorliegenden Fall sind ein erstes Magnetelement 14c und das zweite Magnetelement 16c dazu vorgesehen, in zumindest einem ersten Betriebszustand zusammenzuwirken, um eine lokale Verformung 18c des Aktorelements 10c in dem ersten Teilbereich 22c des Aktorelements 10c zu bewirken (vgl. insbesondere Figuren 6a und 6b).

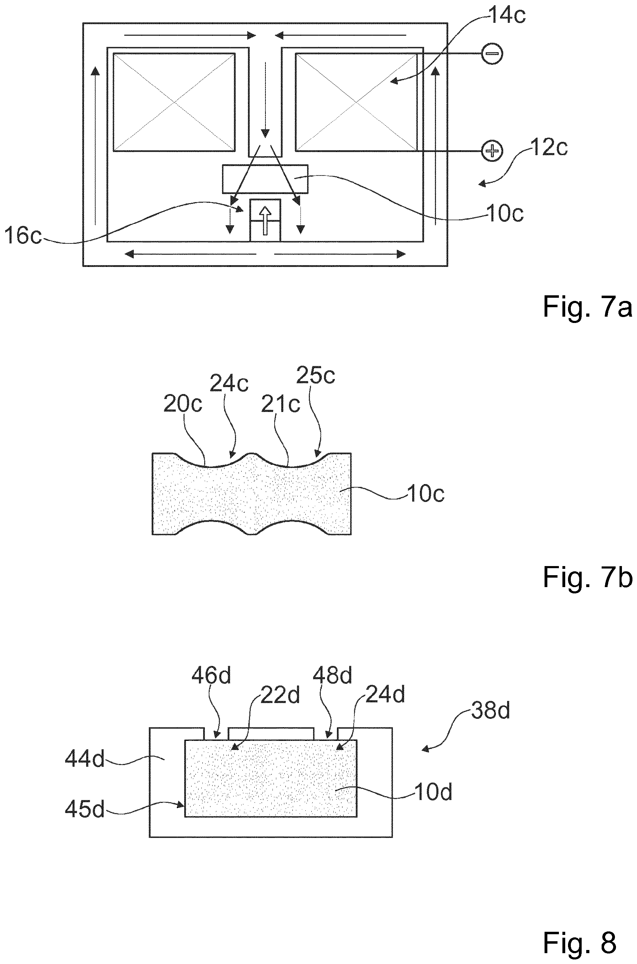

Zudem sind das erste Magnetelement 14c und das zweite Magnetelement 16c dazu vorgesehen, in zumindest einem zweiten Betriebszustand zusammenzuwirken, um eine lokale Verformung 20c des Aktorelements 10c in dem zweiten Teilbereich 24c des Aktorelements 10c und, insbesondere gleichzeitig, eine lokale Verformung 21c des Aktorelements 10c in dem dritten Teilbereich 25c des Aktorelements 10c zu bewirken (vgl. insbesondere Figuren 7a und 7b).

Darüber hinaus können die Magnetelemente 14c, 16c, insbesondere das erste Magnetelement 14c und das zweite Magnetelement 16c, dazu vorgesehen sein, ein veränderliches Magnetfeld zu erzeugen, um eine, insbesondere gleichzeitige, Bewegung der lokalen Verformung 18c, 20c, 21c von dem ersten Teilbereich 22c zu dem zweiten Teilbereich 24c und zu dem dritten Teilbereich 25c zu bewirken. Alternativ oder zusätzlich können die Magnetelemente 14c, 16c, insbesondere das erste Magnetelement 14c und das zweite Magnetelement 16c, dazu vorgesehen sein, ein veränderliches Magnetfeld zu erzeugen, um eine, insbesondere gleichzeitige, Bewegung der lokalen Verformung 18c, 20c, 21c von dem zweiten Teilbereich 24c und von dem dritten Teilbereich 25c zu dem ersten Teilbereich 22c zu bewirken.

In den Figuren 8 bis 10 ist ein weiteres Ausführungsbeispiel der Erfindung gezeigt. Dem Ausführungsbeispiel der Figuren 8 bis 10 ist der Buchstabe d nachgestellt. Das weitere Ausführungsbeispiel der Figuren 8 bis 10 zeigt ein beispielhaftes Anwendungsbeispiel einer Aktorvorrichtung entsprechend der vorherigen Ausführungsbeispiele.

Die Figuren 8 bis 10 zeigen eine beispielhaft als Mikropumpe ausgebildete Fluidpumpe 38d. Die Fluidpumpe 38d ist im vorliegenden Fall zur Verwendung im Automobilbereich, beispielsweise als Dosierpumpe für Kraftstoff, und/oder im Medizinbereich, beispielsweise zur Dosierung von medizinischen Wirkstoffen, vorgesehen.

Die Fluidpumpe 38d umfasst eine erfindungsgemäße Aktorvorrichtung mit einem Aktorelement 10d, wobei auf die Darstellung einer Magneteinheit der Übersichtlichkeit halber verzichtet wurde.

Darüber hinaus umfasst die Fluidpumpe 38d eine Fluidaufnahmeeinheit 44d. Die Fluidaufnahmeeinheit 44d ist als Umhausungseinheit ausgebildet. Die Fluidaufnahmeeinheit 44d ist zumindest im Wesentlichen quaderförmig ausgebildet. Die Fluidaufnahmeeinheit 44d weist eine zu einer Längserstreckung des Aktorelements 10d korrespondierende Längserstreckung auf. Die Fluidaufnahmeeinheit 44d besteht zu wenigstens einem Großteil aus Silikon. Die Fluidaufnahmeeinheit 44d definiert einen, an das Aktorelement 10d angepassten, Aufnahmeraum 45d für das Aktorelement 10d.

Die Fluidaufnahmeeinheit 44d weist ferner eine Einlassöffnung 46d und eine Auslassöffnung 48d auf. Die Einlassöffnung 46d ist zu einer Einleitung eines, im vorliegenden Fall insbesondere flüssigen, Fluids vorgesehen. Die Einlassöffnung 46d ist in einem ersten Randbereich der Fluidaufnahmeeinheit 44d angeordnet. Die Auslassöffnung 48d ist zu einer Ausleitung des Fluids vorgesehen. Die Auslassöffnung 48d ist in einem, dem ersten Randbereich gegenüberliegenden, zweiten Randbereich der Fluidaufnahmeeinheit 44d angeordnet. Die Einlassöffnung 46d und die Auslassöffnung 48d sind im vorliegenden Fall auf einer selben Seite der Fluidaufnahmeeinheit 44d angeordnet.

In einem Betriebszustand ist das Aktorelement 10d zumindest formschlüssig in dem Aufnahmeraum 45d angeordnet, insbesondere derart, dass die Einlassöffnung 46d und die Auslassöffnung 48d an verschiedenen weiteren Randbereichen einer Längsseite des Aktorelements 10d angeordnet sind. Die Einlassöffnung 46d ist dabei einem ersten Teilbereich 22d des Aktorelements 10d zugeordnet. Die Auslassöffnung 48d ist einem zweiten Teilbereich 24d des Aktorelements 10d zugeordnet. Das Aktorelement 10d verschließt eine Fluidleitung, welche die Einlassöffnung 46d mit der Auslassöffnung 48d verbindet. Zudem ist das Aktorelement 10d stoffschlüssig mit der Fluidaufnahmeeinheit 44d verbunden. Dabei ist zumindest eine Längsseite des Aktorelements 10d stoffschlüssig mit der Fluidaufnahmeeinheit 44d verbunden. Im vorliegenden Fall ist eine, der Einlassöffnung 46d und/oder der Auslassöffnung 48d gegenüberliegende, Längsseite des Aktorelements 10d stoffschlüssig mit der Fluidaufnahmeeinheit 44d verbunden. Alternativ könnte eine Fluidaufnahmeeinheit auch aus einem von Silikon abweichenden Material bestehen, wie beispielswiese Kunststoff und/oder Aluminium. Zudem ist denkbar eine Einlassöffnung und/oder eine Auslassöffnung an verschiedenen Stirnseiten eines Aktorelements anzuordnen. Darüber hinaus könnte grundsätzlich auf eine stoffschlüssige Verbindung zwischen einem Aktorelement und einer Fluidaufnahmeeinheit auch verzichtet werden.

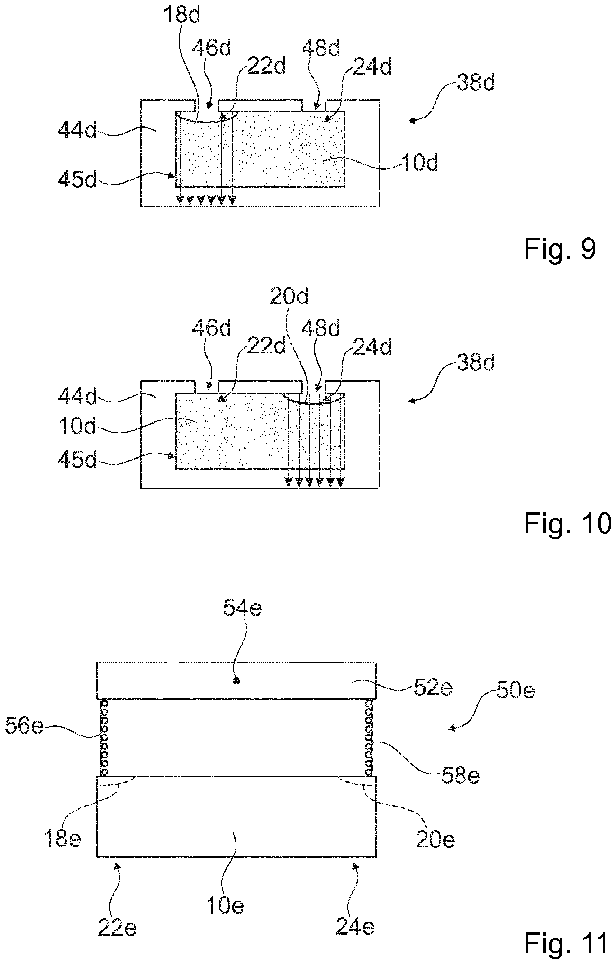

Im vorliegenden Fall sind Magnetelemente der Magneteinheit dazu vorgesehen, in zumindest einem ersten Betriebszustand zusammenzuwirken, um eine lokale Verformung 18d des Aktorelements 10d in dem, insbesondere der Einlassöffnung 46d zugeordneten, ersten Teilbereich 22d des Aktorelements 10d zu bewirken (vgl. insbesondere Figur 9).

Ferner sind die Magnetelemente dazu vorgesehen, in zumindest einem zweiten Betriebszustand zusammenzuwirken, um eine lokale Verformung 20d des Aktorelements 10d in dem, insbesondere der Auslassöffnung 48d zugeordneten, zweiten Teilbereich 24d des Aktorelements 10d zu bewirken (vgl. insbesondere Figur 10).

Zudem sind die Magnetelemente dazu vorgesehen, ein veränderliches Magnetfeld zu erzeugen, um eine, insbesondere gleichförmige, Bewegung der lokalen Verformung 18d, 20d von dem ersten Teilbereich 22d zu dem zweiten Teilbereich 24d zu bewirken. Hierdurch kann eine vorteilhafte Pumpbewegung erreicht und insbesondere das Fluid von der Einlassöffnung 46d zu der Auslassöffnung 48d gefördert werden. Zudem könnte die Fluidpumpe 38d in diesem Fall auch zumindest ein zusätzliches Ventil, vorteilhaft Rückschlagventil, umfassen, insbesondere im Bereich der Einlassöffnung 46d, wodurch vorteilhaft sichergestellt werden kann, dass das Fluid nicht in einen mit der Einlassöffnung 46d verbundenen Versorgungsanschluss zurück gefördert wird. Bevorzugt kann auf ein Rückschlagventil jedoch vollständig verzichtet werden.

Alternativ oder zusätzlich können die Magnetelemente auch dazu vorgesehen sein, ein veränderliches Magnetfeld zu erzeugen, um eine, insbesondere gleichförmige, Bewegung der lokalen Verformung 18d, 20d von dem zweiten Teilbereich 24d zu dem ersten Teilbereich 22d zu bewirken, wodurch insbesondere eine vorteilhafte Reversibilität erreicht werden kann.

In Figur 11 ist ein weiteres Ausführungsbeispiel der Erfindung gezeigt. Dem Ausführungsbeispiel der Figur 11 ist der Buchstabe e nachgestellt. Das weitere Ausführungsbeispiel der Figur 11 zeigt ein weiteres Anwendungsbeispiel einer Aktorvorrichtung entsprechend der vorherigen Ausführungsbeispiele.

Figur 11 zeigt ein beispielhaft als optisches Positionierungssystem ausgebildetes Positionierungssystem 50e. Das Positionierungssystem 50e dient im vorliegenden Fall zur Positionierung zumindest eines optischen Bauelements 52e.

Das optische Bauelement 52e ist beispielhaft als Spiegel ausgebildet und beweglich um eine Lagerachse 54e gelagert.

Zur Positionierung des optischen Bauelements 52e umfasst das Positionierungssystem 50e eine erfindungsgemäßen Aktorvorrichtung mit einem Aktorelement 10e, wobei auf die Darstellung einer Magneteinheit der Übersichtlichkeit halber verzichtet wurde.

Das Aktorelement 10e weist eine Wirkverbindung mit dem optischen Bauelement 52e auf. Dazu umfasst die Aktorvorrichtung zumindest ein Bewegungsübertragungselement 56e, 58e. Im vorliegenden Fall umfasst die Aktorvorrichtung zwei
Bewegungsübertragungselemente 56e, 58e. Die Bewegungsübertragungselemente 56e, 58e sind zumindest im Wesentlichen identisch zueinander. Die
Bewegungsübertragungselemente 56e, 58e sind jeweils als elastisches Element ausgebildet. Die Bewegungsübertragungselemente 56e, 58e sind im vorliegenden Fall jeweils als elastisches Federelement, im vorliegenden Fall insbesondere als Druckfeder, ausgebildet.

Die Bewegungsübertragungselemente 56e, 58e weisen jeweils eine Kontaktverbindung mit dem optischen Bauelement 52e, insbesondere gegenüberliegenden Randbereichen des optischen Bauelements 52e, auf. Zudem weisen die
Bewegungsübertragungselemente 56e, 58e jeweils eine Kontaktverbindung mit dem Aktorelement 10e auf. Ein erstes Bewegungsübertragungselement 56e der Bewegungsübertragungselemente 56e, 58e ist dabei einem ersten Teilbereich 22e des Aktorelements 10e zugeordnet. Ein zweites Bewegungsübertragungselement 58e der Bewegungsübertragungselemente 56e, 58e ist einem zweiten Teilbereich 24e des Aktorelements 10e zugeordnet.

Die Bewegungsübertragungselemente 56e, 58e sind jeweils dazu vorgesehen, eine Bewegung des optischen Bauelements 52e, insbesondere um die Lagerachse 54e, zu bewirken. Im vorliegenden Fall sind die Bewegungsübertragungselemente 56e, 58e dazu vorgesehen, jeweils eine lokale Verformung 18e, 20e des Aktorelements 10e in eine Bewegung des optischen Bauelements 52e umzusetzen und insbesondere derart auf das optische Bauelement 52e zu übertragen, dass sich eine Schwenklage des optische Bauelement 52e um die Lagerachse 54e verändert. Alternativ ist denkbar, zumindest zwei optische Bauelemente mit genau einem Aktorelement zu bewegen. Darüber hinaus ist denkbar mehrere Aktorelemente, wie beispielsweise zumindest drei und/oder zumindest vier Aktorelemente, zur Positionierung genau eines optischen Bauelements zu verwenden. Auch ist denkbar, auf Bewegungsübertragungselemente vollständig zu verzichten und/oder Bewegungsübertragungselemente einstückig mit einem Aktorelement und/oder einem optischen Bauelement auszubilden. In diesem Fall könnten Bewegungsübertragungselemente insbesondere auch formstabil ausgestaltet sein. Zudem könnte ein Aktorelement zu einer linearen Positionierung eines optischen Bauelements verwendet werden.

## Patentansprüche

1. Aktorvorrichtung mit zumindest einem Aktorelement (10a-e), welches zumindest teilweise aus einem magnetisch formveränderlichen Material besteht, und mit einer Magneteinheit (12a-c), welche zumindest ein als Spuleneinheit ausgebildetes erstes Magnetelement (14a-c) und zumindest ein als Permanentmagnet ausgebildetes zweites Magnetelement (16a-c, 17b) umfasst, **dadurch gekennzeichnet, dass** zumindest das erste Magnetelement (14a-c) und das zweite Magnetelement (16a-c; 17b) dazu vorgesehen sind, in zumindest einem Betriebszustand zusammenzuwirken, um eine lokale Verformung (18a-e, 20a-e, 21c) des Aktorelements (10a-e) in einem Teilbereich (22a-e, 24a-e, 25c) des Aktorelements (10a-e) zu bewirken, wobei das Aktorelement (10a-e) dabei in einem von dem Teilbereich (22a-e, 24a-e, 25c) verschiedenen Teilbereich (22a-e, 24a-e, 25c) unverformt bleibt.

2. Aktorvorrichtung nach Anspruch 1, **dadurch gekennzeichnet, dass** zumindest das erste Magnetelement (14a-c) und das zweite Magnetelement (16a-c, 17b) dazu vorgesehen sind, in zumindest einem weiteren Betriebszustand zusammenzuwirken, um eine lokale Verformung (18a-e, 20a-e, 21c) des Aktorelements (10a-e) in einem zumindest teilweise von dem Teilbereich (22a-e, 24a-e, 25c) verschiedenen weiteren Teilbereich (22a-e, 24a-e, 25c) des Aktorelements (10a-e) zu bewirken.

3. Aktorvorrichtung nach Anspruch 2, **dadurch gekennzeichnet, dass** zumindest das erste Magnetelement (14a-c) und das zweite Magnetelement (16a-c, 17b) dazu vorgesehen sind, ein veränderliches Magnetfeld zu erzeugen, um eine Bewegung der lokalen Verformung (18a-e, 20a-e, 21c) von dem Teilbereich (22a-e, 24a-e, 25c) zu dem weiteren Teilbereich (22a-e, 24a-e, 25c) zu bewirken.

4. Aktorvorrichtung nach einem der vorhergehenden Ansprüche, **dadurch gekennzeichnet, dass** das magnetisch formveränderliche Material ein magnetisches Formgedächtnismaterial ist.

5. Aktorvorrichtung nach einem der vorhergehenden Ansprüche, **dadurch gekennzeichnet, dass** das Aktorelement (10a-e) als Vollkörper ausgebildet ist.

6. Aktorvorrichtung nach einem der vorhergehenden Ansprüche, **dadurch gekennzeichnet, dass** das erste Magnetelement (14a-c) und das zweite Magnetelement (16a-c, 17b) auf gegenüberliegenden Seiten des Aktorelements (10a-e) angeordnet sind.

7. Aktorvorrichtung nach einem der vorhergehenden Ansprüche, **dadurch gekennzeichnet, dass** das erste Magnetelement (14a-c) eine Spulenachse (26a) aufweist, welche zumindest im Wesentlichen senkrecht zu einer Längserstreckungsrichtung (28a-c) des Aktorelements (10a-e) ausgerichtet ist.

8. Aktorvorrichtung nach einem der vorhergehenden Ansprüche, **dadurch gekennzeichnet, dass** das zweite Magnetelement (16a-c, 17b) als Seltenerdmagnet ausgebildet ist.

9. Aktorvorrichtung nach einem der vorhergehenden Ansprüche, **dadurch gekennzeichnet, dass** das zweite Magnetelement (16a-c, 17b) beabstandet zu dem Aktorelement (10a-e) angeordnet ist.

10. Aktorvorrichtung nach einem der vorhergehenden Ansprüche, **dadurch gekennzeichnet, dass** das zweite Magnetelement (16a-c, 17b) unbeweglich relativ zu dem Aktorelement (10a-e) ist.

11. Aktorvorrichtung nach einem der vorhergehenden Ansprüche, **dadurch gekennzeichnet, dass** das zweite Magnetelement (16a-b, 17b) eine Magnetisierungsrichtung (30a-b, 31b) aufweist, welche zumindest im Wesentlichen parallel zu einer Längserstreckungsrichtung (28a-b) des Aktorelements (10a-b) ausgerichtet ist.

12. Aktorvorrichtung nach einem der Ansprüche 1 bis 10, **dadurch gekennzeichnet, dass** das zweite Magnetelement (16c) eine Magnetisierungsrichtung (30c) aufweist, welche zumindest im Wesentlichen senkrecht zu einer Längserstreckungsrichtung (28c) des Aktorelements (10c) ausgerichtet ist.

13. Aktorvorrichtung nach einem der vorhergehenden Ansprüche, **dadurch gekennzeichnet, dass** die Magneteinheit (12b) zumindest ein drittes Magnetelement (16b, 17b) aufweist, welches dazu vorgesehen ist, mit dem ersten Magnetelement (14b) und/oder dem zweiten Magnetelement (16b, 17b) zusammenzuwirken, um eine lokale Verformung (18b, 20b) des Aktorelements (10b) zu bewirken.

14. Aktorvorrichtung nach Anspruch 13, **dadurch gekennzeichnet, dass** das dritte Magnetelement (16b, 17b) als Permanentmagnet ausgebildet ist.

15. Aktorvorrichtung nach Anspruch 13 oder 14, **dadurch gekennzeichnet, dass** das dritte Magnetelement (16b, 17b) zumindest im Wesentlichen identisch zu dem zweiten Magnetelement (16b, 17b) ist.

16. Aktorvorrichtung nach einem der Ansprüche 13 bis 15, **dadurch gekennzeichnet, dass** das zweite Magnetelement (16b, 17b) und das dritte Magnetelement (16b, 17b) auf einer selben Seite des Aktorelements (10b) angeordnet sind.

17. Aktorvorrichtung nach einem der vorhergehenden Ansprüche, **dadurch gekennzeichnet, dass** die Magneteinheit (12b) zumindest einen Flusskonzentrator (34b) aufweist, welcher dazu vorgesehen ist, ein auf das Aktorelement (10b) einwirkendes Magnetfeld zu erhöhen.

18. Aktorvorrichtung nach einem der vorhergehenden Ansprüche, **dadurch gekennzeichnet, dass** die Magneteinheit (12a-c) höchstens zwei als Spuleneinheiten ausgebildete Magnetelemente (14a-c) umfasst.

19. Aktor (36a) mit zumindest einer Aktorvorrichtung nach einem der vorhergehenden Ansprüche.

20. Fluidpumpe (38d), insbesondere Mikropumpe, insbesondere zur Verwendung im Automobilbereich und/oder Medizinbereich, mit zumindest einer Aktorvorrichtung nach einem der Ansprüche 1 bis 18.

21. Verfahren mit einer Aktorvorrichtung, insbesondere nach einem der Ansprüche 1 bis 18, wobei die Aktorvorrichtung zumindest ein Aktorelement (10a-e) aufweist, welches zumindest teilweise aus einem magnetisch formveränderlichen Material besteht, und eine Magneteinheit (12a-c) aufweist, welche zumindest ein als Spuleneinheit ausgebildetes erstes Magnetelement (14a-c) und zumindest ein als Permanentmagnet ausgebildetes zweites Magnetelement (16a-c, 17b) umfasst, **dadurch gekennzeichnet, dass** das Aktorelement (10a-e) zumindest mittels Zusammenwirken des ersten Magnetelements (14a-c) und des zweiten Magnetelements (16a-c, 17b) lokal in einem Teilbereich (22a-e, 24a-e, 25c) verformt wird, wobei das Aktorelement (10a-e) dabei in einem von dem Teilbereich (22a-e, 24a-e, 25c) verschiedenen Teilbereich (22a-e, 24a-e, 25c) unverformt bleibt.

## Claims

1. Actuator device with at least one actuator element (10a-e) which is at least partially composed of a magnetically shape-shiftable material, and with a magnet unit (12a-c) comprising at least one first magnetic element (14a-c) that is implemented as a coil unit and at least one second magnetic element (16a-c, 17b) that is implemented as a permanent magnet,
**characterised in that** at least the first magnetic element (14a-c) and the second magnetic element (16a-c, 17b) are configured for interacting in at least one operation state so as to cause a local deformation (18a-e, 20a-e, 21c) of the actuator element (10a-e) in a partial region (22a-e, 24a-e, 25c) of the actuator element (10a-e), the actuator element (10a-e) remaining non-deformed in a partial region (22a-e, 24a-e, 25c) that differs from the partial region (22a-e, 24a-e, 25c).

2. Actuator device according to claim 1,
**characterised in that** at least the first magnetic element (14a-c) and the second magnetic element (16a-c, 17b) are configured for interacting in at least one further operation state so as to cause a local deformation (18a-e, 20a-e, 21c) of the actuator element (10a-e) in a further partial region (22a-e, 24a-e, 25c) of the actuator element (10a-e) that at least partially differs from the partial region (22a-e, 24a-e, 25c).

3. Actuator device according to claim 2,
**characterised in that** at least the first magnetic element (14a-c) and the second magnetic element (16a-c, 17b) are configured to create a variable magnetic field so as to cause a movement of the local deformation (18a-e, 20a-e, 21c) from the partial region (22a-e, 24a-e, 25c) to the further partial region (22a-e, 24a-e, 25c).

4. Actuator device according to one of the preceding claims,
**characterised in that** the magnetically shape-shiftable material is a magnetic shape-memory material.

5. Actuator device according to one of the preceding claims,
**characterised in that** the actuator element (10a-e) is realised as a solid body.

6. Actuator device according to one of the preceding claims,
**characterised in that** the first magnetic element (14a-c) and the second magnetic element (16a-c, 17b) are arranged on opposite sides of the actuator element (10a-e).

7. Actuator device according to one of the preceding claims,
**characterised in that** the first magnetic element (14a-c) has a coil axis (26a) which is aligned at least substantially perpendicularly to a longitudinal extension direction (28a.c) of the actuator element (10a-e).

8. Actuator device according to one of the preceding claims,
**characterised in that** the second magnetic element (16a-c, 17b) is embodied as a rare-earth magnet.

9. Actuator device according to one of the preceding claims,
**characterised in that** the second magnetic element (16a-c, 17b) is arranged spaced apart from the actuator element (10a-e).

10. Actuator device according to one of the preceding claims,
**characterised in that** the second magnetic element (16a-c, 17b) is immobile relative to the actuator element (10a-e).

11. Actuator device according to one of the preceding claims,
**characterised in that** the second magnetic element (16a-b, 17b) has a magnetisation direction (30a-b, 31b) that is aligned at least substantially parallel with a longitudinal extension direction (28a-b) of the actuator element (10a-b).

12. Actuator device according to one of claims 1 to 10,
**characterised in that** the second magnetic element (16c) has a magnetisation direction (30c) that is oriented at least substantially perpendicularly to a longitudinal extension direction (28c) of the actuator element (10c).

13. Actuator device according to one of the preceding claims,
**characterised in that** the magnet unit (12b) comprises at least one third magnetic element (16b, 17b), which is configured for interacting with the first magnetic element (14b) and/or the second magnetic element (16b, 17b) so as to cause a local deformation (18b, 20b) of the actuator element (10b).

14. Actuator device according to claim 13,
**characterised in that** the third magnetic element (16b, 17b) is embodied as a permanent magnet.

15. Actuator device according to claim 13 or 14,
**characterised in that** the third magnetic element (16b, 17b) is at least substantially identical to the second magnetic element (16b, 17b).

16. Actuator device according to one of claims 13 to 15,
**characterised in that** the second magnetic element (16b, 17b) and the third magnetic element (16b, 17b) are arranged on a same side of the actuator element (10b).

17. Actuator device according to one of the preceding claims,
**characterised in that** the magnet unit (12b) comprises at least one flux concentrator (34b), which is configured for augmenting a magnetic field that acts onto the actuator element (10b).

18. Actuator device according to one of the preceding claims,
**characterised in that** the magnet unit (12a-c) comprises maximally two magnetic elements (14a-c) which are embodied as coil units.

19. Actuator (36a) with at least one actuator device according to one of the preceding claims.

20. Fluid pump (38d), in particular a micropump, in particular for use in the automotive sector and/or the medical sector, with at least one actuator device according to one claims 1 to 18.

21. Method with an actuator device, in particular according to one of claims 1 to 18, wherein the actuator device has at least one actuator element (10a-e), which is at least partially composed of a magnetically shape-shiftable material, and has a magnet unit (12a-c) comprising at least one first magnetic element (14a-c) that is implemented as a coil unit and at least one second magnetic element (16a-c, 17b) that is implemented as a permanent magnet,
**characterised in that** the actuator element (10a-e) is locally deformed in a partial region (22a-e, 24a-e, 25c) at least by an interaction of the first magnetic element (14a-c) and the second magnetic element (16a-c, 17b), the actuator element (10a-e) remaining non-deformed in a partial region (22a-e, 24a-e, 25c) that differs from the partial region (22a-e, 24a-e, 25c).

## Revendications

1. Dispositif d'actionneur avec au moins un élément d'actionnement (10a-e) composé au moins partiellement d'un matériau changeant-forme magnétiquement, et avec une unité magnétique (12a-c) comprenant au moins un premier élément magnétique (14a-c) réalisé comme unité de bobine et au moins un deuxième élément magnétique (16a-c, 17b) réalisé comme aimant permanent,
**caractérisé en ce qu'**au moins le premier élément magnétique (14a-c) et le deuxième élément magnétique (16a-c ; 17b) sont prévus à coopérer dans au moins un état d'opération pour effectuer une déformation locale (18a-e, 20a-e, 21c) de l'élément actionneur (10a-e) dans une zone partielle (22a-e, 24a-e, 25c) de l'élément actionneur (10a-e), l'élément actionneur restant non-déformé dans une zone partielle (22a-e, 24a-e, 25c) différant de la zone partielle (22a-e, 24a-e, 25c).

2. Dispositif d'actionneur selon la revendication 1,
**caractérisé en ce qu'**au moins le premier élément magnétique (14a-c) et le deuxième élément magnétique (16a-c, 17b) sont prévus à coopérer dans au moins un autre état d'opération pour effectuer une déformation locale (18a-e, 20a-e, 21c) de l'élément actionneur (10a-e) dans une zone partielle de plus (22a-e, 24a-e, 25c) de l'élément actionneur (10a-e), ladite zone partielle de plus (22a-e, 24a-e, 25c) différant au moins en partie de la zone partielle (22a-e, 24a-e, 25c).

3. Dispositif d'actionneur selon la revendication 2,
**caractérisé en ce que** le premier élément magnétique (14a-c) et le deuxième élément magnétique (16a-c, 17b) sont prévus à générer un champ magnétique variable pour le bût d'effectuer un mouvement de la déformation locale (18a-e, 20a-e, 21c) de la zone partielle (22a-e, 24a-e, 25c) à la zone partielle de plus (22a-e, 24a-e, 25c).

4. Dispositif d'actionneur selon l'une des revendications précédentes,
**caractérisé en ce que** le matériau changeant-forme magnétiquement est un matériau à mémoire de forme magnétique.

5. Dispositif d'actionneur selon l'une des revendications précédentes,
**caractérisé en ce que** l'élément actionneur (10a-e) est réalisé comme corps plein.

6. Dispositif d'actionneur selon l'une des revendications précédentes,
**caractérisé en ce que** le premier élément magnétique (14a-c) et le deuxième élément magnétique (16a-c, 17b) sont disposés sur des côtés opposés de l'élément actionneur (10a-e).

7. Dispositif d'actionneur selon l'une des revendications précédentes,
**caractérisé en ce que** le premier élément magnétique (14a-c) comprend un axe de bobine (26a) orienté au moins sensiblement perpendiculairement à une direction d'étendue longitudinale (28a-c) de l'élément actionneur (10a-e).

8. Dispositif d'actionneur selon l'une des revendications précédentes,
**caractérisé en ce que** le deuxième élément magnétique (16a-c, 17b) est réalisé comme aimant aux terres rares.

9. Dispositif d'actionneur selon l'une des revendications précédentes,
**caractérisé en ce que** le deuxième élément magnétique (16a-c, 17b) est agencé à l'écart de l'élément actionneur (10a-e).

10. Dispositif d'actionneur selon l'une des revendications précédentes,
**caractérisé en ce que** le deuxième élément magnétique (16a-c, 17b) est immobile par rapport à l'élément actionneur (10a-e).

11. Dispositif d'actionneur selon l'une des revendications précédentes,
**caractérisé en ce que** le deuxième élément magnétique (16a-b, 17b) comporte une direction de magnétisation (30a-b, 31b) orientée au moins sensiblement en parallèle à une direction d'étendue longitudinale (28a-b) de l'élément actionneur (10a-b).

12. Dispositif d'actionneur selon l'une des revendications 1 à 10,
**caractérisé en ce que** le deuxième élément magnétique (16c) comporte une direction de magnétisation (30c) orientée au moins sensiblement perpendiculairement à une direction d'étendue longitudinale (28c) de l'élément actionneur (10c).

13. Dispositif d'actionneur selon l'une des revendications précédentes,
**caractérisé en ce que** l'unité magnétique (12b) comprend un troisième élément magnétique (16b, 17b) qui est prévu à coopérer avec le premier élément magnétique (14b) et/ou le deuxième élément magnétique (16b, 17b) pour le bût d'effectuer une déformation locale (18b, 20b) de l'élément actionneur (10b).

14. Dispositif d'actionneur selon la revendication 13,
**caractérisé en ce que** le troisième élément magnétique (16b, 17b) est réalisé comme aimant permanent.

15. Dispositif d'actionneur selon la revendication 13 ou 14,
**caractérisé en ce que** le troisième élément magnétique (16b, 17b) est au moins sensiblement identique au deuxième élément magnétique (16b, 17b).

16. Dispositif d'actionneur selon l'une des revendications 13 à 15,
**caractérisé en ce que** le deuxième élément magnétique (16b, 17b) et le troisième élément magnétique (16b, 17b) sont disposés sur un même côté de l'élément actionneur (10b).

17. Dispositif d'actionneur selon l'une des revendications 1 à 10,
**caractérisé en ce que** l'unité magnétique (12b) comporte au moins un concentrateur de flux (34b) prévu à augmenter un champ magnétique agissant sur l'élément actionneur (10b).

18. Dispositif d'actionneur selon l'une des revendications précédentes,
**caractérisé en ce que** l'unité magnétique (12a-c) comporte maximalement deux éléments magnétiques (14a-c) réalisés comme unités de bobine.

19. Actionneur (36a) avec au moins un dispositif d'actionneur selon l'une des revendications précédentes.

20. Pompe à fluide (38d), en particulier micropompe, en particulier pour l'utilisation dans le secteur automotif et/ou le secteur médical, avec au moins un dispositif d'actionneur selon l'une des revendications 1 à 18.

21. Procédé avec un dispositif d'actionnement, en particulier selon l'une des revendications 1 à 18, où le dispositif d'actionneur comprend au moins un élément actionneur (10a-e) composé au moins partiellement d'un matériau changeant-forme magnétiquement, et comprend une unité magnétique (12a-c) qui comporte au moins un premier élément magnétique (14a-c) réalisé comme unité de bobine et au moins un deuxième élément magnétique (16a-c, 17b) réalisé comme aimant permanent,
**caractérisé en ce que** l'élément actionneur (10a-e) est déformé localement dans une zone partielle (22a-e, 24a-e, 25c) au moins par une coopération du premier élément magnétique (14a-c) et du deuxième élément magnétique (16a-c, 17b), l'élément actionneur (10a-e) restant non-déformé dans une zone partielle (22a-e, 24a-e, 25c) différant de la zone partielle (22a-e, 24a-e, 25c).
